Europäisches Patentamt

European Patent Office

Office européen des brevets

(11) Veröffentlichungsnummer: **0 003 776**

A1

# EUROPÄISCHE PATENTANMELDUNG

(21) Anmeldenummer: 79100365.0

(22) Anmeldetag: 08.02.79

(51) Int. Cl.²: **G 01 R 11/14**
G 01 R 1/10, G 01 D 11/02
F 16 C 39/06

(30) Priorität: 21.02.78 DE 2807399

(43) Veröffentlichungstag der Anmeldung:
05.09.79 Patentblatt 79/18

(84) Benannte Vertragsstaaten:
BE CH FR GB IT NL SE

(71) Anmelder: SIEMENS AKTIENGESELLSCHAFT Berlin
und München
Postfach 261
D-8000 München 22(DE)

(72) Erfinder: Petrak, Heinz
Schupferstrasse 32
D-8500 Nürnberg(DE)

(72) Erfinder: Vieweg, Gunther, Dipl.-Phys
Kesslerplatz 13a
D-8500 Nürnberg(DE)

(72) Erfinder: Welnicke, Martin
Bibertstrasse 50
D-8500 Nürnberg(DE)

(54) **Nadelhalslager für eine magnetisch gelagerte Läuferwelle eines Messgerätes, insbesondere eines Elektrizitätszählers.**

(57) Die Erfindung betrifft ein Nadelhalslager für eine magnetisch gelagerte Läuferwelle (1) eines Meßgerätes, insbesondere eines Elektrizitätszählers, bei dem eine aus Stahl oder einem anderen Metall bestehende dünne Lagernadel (12) in eine Nadelführung (14) aus einem Kunststoff mit guten Verschleiß- und Reibungseigenschaften hineinragt. Bei einem derartigen Nadelhalslager besteht das Problem, eine reibungs- und verschleißarme Führung der Läuferwelle (1) in fertigungstechnisch günstiger Weise zu erreichen. Dabei soll gleichzeitig die Präzision der Führung und eine gute Kühlung des Lagers gewährleistet sein. Dieses Problem wird durch die Erfindung derart gelöst, daß die Lagernadel (12) zumindest in dem mit der Nadelführung (14) zusammenwirkenden Bereich mit einem Überzug mit guten Gleiteigenschaften versehen ist, wobei der Überzug als eine auf die Lagernadel (12) aufsteckbare Hülse (20) ausgebildet ist. Durch die Aufsteckbarkeit der Hülse (20) kann der Überzug in einfacher Weise auf die Lagernadel (12) aufgebracht oder ausgetauscht werden (Figur).

EP 0 003 776 A1

SIEMENS AKTIENGESELLSCHAFT          Unser Zeichen
Berlin und München                  VPA 78 P 3027 EPC

Nadelhalslager für eine magnetisch gelagerte Läuferwelle
eines Meßgerätes, insbesondere eines Elektrizitätszählers

Die Erfindung betrifft ein Nadelhalslager für eine magnetisch gelagerte Läuferwelle eines Meßgerätes, insbesondere eines Elektrizitätszählers, bei dem eine aus Stahl oder einem anderen Metall bestehende dünne Lagernadel in eine Nadelführung aus einem Kunststoff mit guten Verschleiß- und Reibungseigenschaften hineinragt. Ein derartiges Nadellager ist aus der DE-AS 12 11 054 oder der Zeitschrift "Technica", Nr. 1, Januar 1965, Seite 28 bekannt.

Derartige Nadelhalslager dienen bei magnetischen Traglagern zur stabilen Seitenführung der einander gegenüberstehenden Magnetringpaare. Es hat sich gezeigt, daß die Lagerstelle zwischen Lagernadel und Nadelführung

Spl 2 Bim / 7.12.1978

einem erhöhten Verschleiß unterliegt, was dadurch zu erklären ist, daß zusätzlich zur rotierenden eine schwingende Beanspruchung der Lagerstelle auftritt.

Aus der FR-PS 11 13 014 sind Spitzen-, Zapfen- und Messerlager bekannt, bei denen zum Schutz der Gleitflächen diese mit nitrierten, borierten oder silizierten Überzügen aus Metallen der dritten und sechsten Gruppe des Periodensystems versehen sind.

Aus der GB-PS 11 43 942 ist ein Schallgeber bekannt, bei dem die Außenfläche des zylindrischen Klöppels und/oder dessen hohlzylindrische Führung mit PTFE-Überzügen versehen sind, indem Suspensionen dieses Werkstoffes auf die Oberflächen aufgetragen und bei erhöhter Temperatur verfestigt werden.

Aus der GB-PS 536 972 ist ein Unterlager für Meßgeräte mit einer drehbaren Welle bekannt, bei dem die Lagerschale und der Lagerzapfen aus Kunststoff gefertigt und mit der Welle verbunden sind. Der Lagerzapfen ist entweder mit Hilfe einer Metallhülse endseitig an der Welle befestigt oder selbst auf die Welle aufsteckbar. Abstützung und Führung der Welle erfolgt durch den massiven Lagerzapfen aus Kunststoff, so daß an die Präzision der Führung keine hohen Ansprüche gestellt werden können. Darüber hinaus ist das Problem der Wärmeabfuhr aus dem Lager nicht befriedigend gelöst.

In diesem Zusammenhang ist aus der Zeitschrift "Feinwerktechnik", 72. Jahrgang, 1968, Heft 2, Seite 92 bekannt, daß der Verschleiß von Kunststofflagern wegen der schlechten Wärmeleitfähigkeit mit der Zeit ansteigt.

Aus der VDI-Zeitschrift 110 (1968), Nr. 7, Seite 279 ist es bekannt, Lagerbuchsen mit einer Trägerschicht aus einem porösen Sintermetall aus Eisen und Kupfer sowie einer Gleitschicht aus Bleibronze und Graphit zu versehen.

In der Zeitschrift "Feinwerktechnik", Jahrgang 59, 1955, Heft 1, Seiten 10 bis 15 ist dad Thema "Polyamide als Konstruktionswerkstoffe der Feinwerktechnik" erörtert. Hierbei ist im Zusammenhang mit der raschen Abfuhr der Reibungswärme die Möglichkeit angegeben, auf eine Stahlwelle eine dünne Schicht Polyamid aufzuschmelzen. Im übrigen wird vorzugsweise auf die Lagerpaarung Metall - Polyamid hingewiesen. Das Aufschmelzen von Polyamid auf Metall mit der bei Nadellagern erforderlichen hohen Präzision ist fertigungstechnisch aufwendig. Darüber hinaus ist nach Verschleiß des Polyamidüberzuges auf einem Lagerelement der Ersatz des gesamten Lagerelementes unumgänglich.

Der Erfindung liegt die Aufgabe zugrunde, ein Nadelhalslager der eingangs genannten Art zu schaffen, das eine reibungs- und verschleißarme Abstützung der Läuferwelle in fertigungstechnisch günstiger Weise ermöglicht, wobei gleichzeitig die Präzision der Führung und eine gute Kühlung des Lagers erhalten bleiben soll.

Diese Aufgabe wird erfindungsgemäß dadurch gelöst, daß die Lagernadel zumindest in dem mit der Nadelführung zusammenwirkenden Bereich mit einem Überzug mit guten Gleiteigenschaften versehen ist, wobei der Überzug als eine auf die Lagernadel aufsteckbare Hülse ausgebildet ist. Damit ist ein leichtes Anbringen und Austauschen des Überzuges jederzeit möglich, ohne daß - nach Verschleiß des Überzuges - die gesamte Lagernadel ausgetauscht werden muß. Die Stabilität und Präzision der Führung wird durch die als Kern in der aufsteckbaren Hülse befindlichen metallische Lagernadel gewährleistet. Die im Lager auftretende Reibungswärme wird durch die metallische Lagernadel zuverlässig und schnell abgeführt.

In einer bevorzugten Ausführungsform weist die Hülse einen Bund auf, der das Aufbringen der Hülse erleichtert und im Bereich des Bundes für eine erhöhte Anpressung der Hülse an die Lagernadel sorgt.

Die Hülse kann aus Kunststoff gefertigt sein, so daß bezüglich der Gleitflächen eine Kunststoff-Kunststoff-Paarung zustandekommt, die im Hinblick auf die bei derartigen Nadelhalslagern auftretende Schwingungsbelastung besonders gute Dämpfungseigenschaften entwickelt.

Vorzugsweise besteht die Nadelführung aus Polyoxymethylen und die Hülse aus Polyamid. Diese Werkstoffpaarung weist besonders gute Gleiteigenschaften auf.

Es ist fertigungstechnisch vorteilhaft, wenn die Nadelführung als Bohrung in einer mit dem Ende der Läuferwelle verbundenen, einen kreisringförmigen Magneten tragenden Kunststoffnabe ausgebildet ist.

In einer bevorzugten Ausführungsform verläuft die Bohrung in einem zylindrischen Ansatz der Kunststoffnabe. Damit wird in fertigungstechnisch einfacher Weise ein hinreichender Abstand zwischen dem Ende der Läuferwelle und dem Ende der Lagernadel geschaffen.

Um die Lagernadel gegen Verbiegung infolge von Transportstößen zu schützen, kann der zylindrische Ansatz bis ins Innere eines Kragens der Nadelhülse reichen. Damit ist ein seitlicher Anschlag vorgegeben, der die Lagernadel beim Auftreten hoher Kräfte senkrecht zur Längserstreckung der Lagernadel schützt.

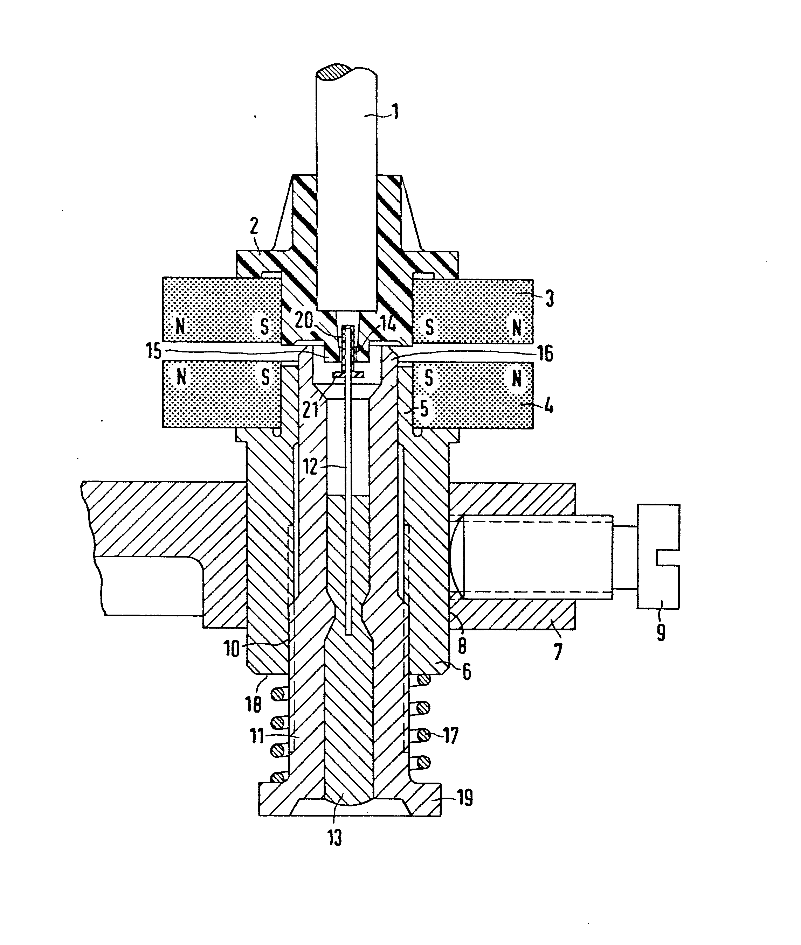

Die Erfindung wird im folgenden anhand des in der Zeichnung dargestellten Ausführungsbeispiels näher erläutert. Mit 1 ist eine Läuferwelle bezeichnet, deren unteres Ende eine Nabe 2 aus einem Thermoplatz trägt, auf der ein kreisringförmiger Magnet 3 angeordnet ist. Dieser Magnet ist in der bezeichneten Weise radial magnetisiert. Der Magnet 3 wirkt mit einem kreisringförmigen Magneten 4 zusammen, der am oberen abgesetzten Ende 5 einer Führungshülse 6 befestigt ist. Die Führungshülse 6 ist in einem Meßwerkträger 7 in einer Bohrung 8 mit Hilfe einer Schraube 9 höhenverstellbar befestigt. Die Führungshülse 6 ist im Inneren mit einem Gewinde 10 versehen, so daß in die Bohrung der Hülse 6 eine Nadelhülse 11 einführbar ist. In einer Bohrung der Nadelhülse ist eine Lagernadel 12 eingegossen, wie durch 13 angedeutet ist. Die Lagernadel 12 erstreckt sich bis in eine als Nadelführung ausgebildete Bohrung 14 eines zylindrischen Ansatzes 15 der Thermoplatznabe 2. Die Nabe 2 übernimmt somit gleichzeitig die Funktion der Nadelführung. Vorzugsweise wird die Nabe aus einem Kunststoff mit guten Lagereigenschaften hergestellt.

Der zylindrische Ansatz 15 der Nabe 2 reicht bis ins Innere eines Kragens 16 der Nadelhülse 11, so daß die Lagernadel 12 gegen Verbiegen infolge von Transportstößen geschützt ist.

Ferner ist zwischen der Führungshülse 6 und der Nadelhülse 11 eine Druckfeder 17 eingeschaltet, die sich einerseits gegen die Stirnseite der Führungshülse 6 und andererseits gegen einen Kopf 19 der Nadelhülse 11 abstützt.

Gemäß der Erfindung wird zur Verschleißminderung die bisher verwendete Lagernadel aus Stahl im Bereich der Lagerstelle mit einem Kunststoffüberzug versehen, der aus einer Kunststoffhülse 20 besteht. Die Hülse ist topfförmig ausgebildet, so daß durch den Boden des Topfes eine Verschiebung der Hülse 20 nach unten ausgeschlossen ist. Darüber hinaus weist die Hülse einen Bund 21 auf, der die Festigkeit des Sitzes der Hülse 20 auf der Nadel 12 erhöht und auch das Aufschieben der Hülse 20 auf die Nadel 12 erleichtert.

0003776

<u>Patentansprüche</u>

1. Nadelhalslager für eine magnetisch gelagerte Läuferwelle eines Meßgerätes, insbesondere eines Elektrizitätszählers, bei dem eine aus Stahl oder einem anderen Metall bestehende dünne Lagernadel in eine Nadelführung aus einem Kunststoff mit guten Verschleiß- und Reibungseigenschaften hineinragt, d a d u r c h   g e k e n n - z e i c h n e t ,   daß die Lagernadel (12) zumindest in dem mit der Nadelführung (14) zusammenwirkenden Bereich mit einem Überzug mit guten Gleiteigenschaften versehen ist, wobei der Überzug als eine auf die Lagernadel (12) aufsteckbare Hülse (20) ausgebildet ist.

2. Nadelhalslager nach Patentanspruch 1, d a d u r c h g e k e n n z e i c h n e t ,   daß die Hülse (20) einen Bund (21) aufweist.

3. Nadelhalslager nach Patentanspruch 1 oder 2,   d a - d u r c h   g e k e n n z e i c h n e t ,   daß die Hülse (20) aus Kunststoff gefertigt ist.

4. Nadelhalslager nach einem der Patentansprüche 1 bis 3, d a d u r c h   g e k e n n z e i c h n e t ,   daß die Nadelführung (14) aus Polyoxymethylen und die Hülse (20) aus Polyamid besteht.

5. Nadelhalslager nach einem der Patentansprüche 1 bis 4, d a d u r c h   g e k e n n z e i c h n e t ,   daß die Nadelführung (14) als Bohrung in einer mit dem Ende der Läuferwelle verbundenen, einen kreisringförmigen Magneten (3) tragenden Kunststoffnabe (2) ausgebildet ist.

0003776

- 2 -     VPA 78 P 3027 EPC

6. Nadelhalslager nach einem der Patentansprüche 1 bis 5,
d a d u r c h     g e k e n n z e i c h n e t ,    daß die
Bohrung in einem zylindrischen Ansatz (15) der Kunststoffnabe (2) verläuft.

7. Nadelhalslager nach Patentanspruch 6,    d a d u r c h
g e k e n n z e i c h n e t ,    daß der zylindrische
Ansatz (15) bis ins Innere eines Kragens (16) der Nadelhülse (11) reicht.

**Europäisches
Patentamt**

**EUROPÄISCHER RECHERCHENBERICHT**

| | EINSCHLÄGIGE DOKUMENTE | | KLASSIFIKATION DER ANMELDUNG (Int Cl.²) |
|---|---|---|---|
| Kategorie | Kennzeichnung des Dokuments mit Angabe, soweit erforderlich, der maßgeblichen Teile | betrifft Anspruch | |
| A | DE - A - 2 116 149 (H. KRETSCHMER) <br> * Seite 1; Figur * <br><br> -- | 1,3 | G 01 R 11/14 <br> 1/10 <br> G 01 D 11/02 <br> F 16 C 39/06 |
| A | GB - A - 231 712 (GEORGE WALL) <br> * Seite 2, Zeilen 82-88; Figur 3 * <br><br> ---- | 1 | |

**RECHERCHIERTE SACHGEBIETE (Int Cl.²)**

G 01 R 11/14
 11/12
 1/10
G 01 D 11/00
 11/02
F 16 C 39/00
 39/06
 17/02

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 23-05-1979 | KUSCHBERT |

EPA form 1503.1 06.78